# EUROPEAN PATENT APPLICATION

(11) **EP 2 916 145 A1**
(43) Date of publication of application: **09.09.2015**
(21) Application number: 13850661.3
(22) Date of filing: 22.10.2013
(51) Int. Cl.: G01T 1/20

(54) **RADIATION DETECTION DEVICE AND MANUFACTURING METHOD THEREFOR**

(30) Priority: 01.11.2012 JP 2012241512
(71) Applicant: Toray Industries, Inc., Tokyo, 103-8666 (JP)
(72) Inventor: OKAMURA, Masaki, Otsu-shi Shiga 520-8558 (JP); IGUCHI, Yuichiro, Otsu-shi Shiga 520-8558 (JP); MURAI, Takahiro, Otsu-shi Shiga 520-8558 (JP)
(74) Representative: Kador & Partner
(86) International application number: PCT/JP2013/078560
(87) International publication number: WO 2014/069284

(57) **Abstract**

The present invention provides a radiation detection device which is provided with a narrow-width barrier rib with high accuracy in a large area, and also has high luminous efficiency and realizes clear image quality. The present invention provides a radiation detection device, including a substrate, on which a barrier rib is provided, and a light detector, which face each other, wherein cells divided by the barrier rib are formed in a space between the substrate and the light detector, the cells are filled with a phosphor, a light detection pixel is provided on a surface of the light detector which is not in contact with the barrier rib, and an adhesive layer is formed between the barrier rib and the phosphor, and the light detector.

## Description

### [Technical Field]

The present invention relates to a radiation detection device which is used for a medical diagnostic apparatus, a nondestructive inspection instrument, and the like.

### [Background Art]

Heretofore, X-ray images using films have widely been used in medical settings. However, the X-ray image using a film provides analog image information, and thus digital radiation detection devices such as computed radiography (CR) and flat panel radiation detection devices (flat panel detectors: FPDs) have recently been developed.

In a flat panel X-ray detector (FPD), a scintillator panel is used for converting radiation into visible light. The scintillator panel contains an X-ray phosphor such as cesium iodide (CsI) and the X-ray phosphor emits visible light in response to applied X-ray, and the emitted light is converted into an electric signal by a thin film transistor (TFT) or a charge-coupled device (CCD) to thereby convert X-ray information into digital image information. However, the FPD has a problem such as a low S/N ratio. In order to increase the S/N ratio, there have been proposed methods of irradiating with X-ray from a light detector side (Patent Literatures 1 and 2), and also there have been proposed methods of filling cells divided by a barrier rib with an X-ray phosphor, so as to reduce an influence of the scattering of visible light due to the X-ray phosphor (Patent Literatures 3 to 6).

The method which has hitherto been used as a method for forming the barrier rib is a method of etching a silicon wafer, or a method in which a glass paste as a mixture of a pigment or a ceramic powder and a low melting point glass powder is pattern-printed in multiple layers using a screen printing method, and then fired to form a barrier rib. However, in the method of etching a silicon wafer, the size of a formable scintillator panel is limited by the size of the silicon wafer, and a scintillator panel having a large size of 500 mm square could not be obtained. A plurality of small-size panels should be arranged for making a large-size panel. However, it is difficult to produce the scintillator panel in view of accuracy, and a large-area scintillator panel was scarcely produced.

In the multi-layer screen printing method using a glass paste, it is difficult to process with high accuracy due to a dimensional variation of a screen printing sheet, or the like. When multi-layer screen printing is performed, a definite barrier rib width is required for increasing the strength of a barrier rib in order to prevent destructive defects of the barrier rib. However, if the width of the barrier rib increases, a space between barrier ribs becomes relatively small, so that a volume available for filling an X-ray phosphor decreases, and the filling amount is not uniform. Therefore, a scintillator panel obtained in this method has a disadvantage such as a decrease in luminescence or occurrence of luminous unevenness because of too small amount of an X-ray phosphor. This disadvantage of flexibility is an obstacle to formation of clear images in photographing at a low dose.

### [Citation List]

### [Patent Literature]

### [Patent Literature 1]

Japanese Patent No. 3333278

### [Patent Literature 2]

Japanese Patent Laid-Open Publication No. 2001-330677

### [Patent Literature 3]

Japanese Patent Laid-Open Publication No. 5-60871

### [Patent Literature 4]

Japanese Patent Laid-Open Publication No. 5-188148

### [Patent Literature 5]

Japanese Patent Laid-Open Publication No. 2011-188148

### [Patent Literature 6]

Japanese Patent Laid-Open Publication No. 2011-007552

### [Summary of Invention]

### [Technical Problem]

Production of a scintillator panel having high luminous efficiency and is capable of realizing clear images requires technology for processing a barrier rib, capable of processing with high accuracy in a large area and reducing the width of the barrier rib, and technology for preventing visible light emitted by a phosphor from leaking outside the barrier rib.

An object of the present invention is to solve the problems mentioned above and to provide a radiation detection device which is provided with a narrow-width barrier rib with high accuracy in a large area, and also has high luminous efficiency and realizes clear image quality.

### [Solution to Problem]

This obj ect is achieved by any one of the following technical means:
(1) A radiation detection device, including a substrate on which a barrier rib is provided, and a light detector, which face each other, wherein cells divided by the barrier rib are formed in a space between the substrate and the light detector, the cells are filled with a phosphor, a light detection pixel is provided on a surface of the light detector in the place that is not in contact with the barrier rib, and an adhesive layer is formed between the barrier rib and the phosphor, and the light detector;
(2) The radiation detection device according to the above (1), wherein the adhesive layer is formed of a resin selected from the group consisting of an acrylic resin, an epoxy resin, a polyester resin, a butyral resin, a polyamide resin, a silicone resin, and an ethyl cellulose resin;
(3) The radiation detection device according to the above (1) or (2), wherein a height L1 of the barrier rib is larger than a distance L2 of an adjacent barrier rib, and also a width L3 at the interface where the barrier rib and the substrate are in contact with each other is larger than a width L4 of the top of the barrier rib;
(4) The radiation detection device according to any one of the above (1) to (3), which satisfies a relation: λ2 ≥ λ1 ≥ λ3, where λ1, λ2, and λ3 respectively denote an average refractive index of the phosphor, an average refractive index of the light detection pixel, and an average refractive index of the adhesive layer;
(5) The radiation detection device according to any one of the above (1) to (4), wherein radiation is incident from the light detector side;
(6) The radiation detection device according to the above (5), wherein the substrate includes a radiation shielding layer on a surface;
(7) The radiation detection device according to the above (5) or (6), wherein the substrate is made of a radiation shielding material;
(8) The radiation detection device according to any one of the above (1) to (7), wherein the barrier rib is made of a material containing, as a main component, a low melting point glass containing 2 to 20% by mass of an alkali metal oxide;
(9) The radiation detection device according to any one of the above (1) to (8), wherein a reflecting film is formed on a surface of the barrier rib, and a face on the substrate on which the barrier rib is not formed; and
(10) A method for manufacturing a scintillator panel, the method including: a step of forming a photosensitive paste coating film by applying a photosensitive paste containing a low melting point glass and a photosensitive organic component onto a substrate; an exposure step of exposing the obtained photosensitive paste coating film to light; a development step of dissolving and removing a part of the exposed photosensitive paste coating film which is soluble in a developer; a firing step of heating the photosensitive paste coating film pattern after development to a firing temperature of 500°C to 700°C to thereby remove the organic component, and soften and sinter the low melting point glass, thus forming a barrier rib; a step of filling cells divided by the barrier rib with a phosphor; a step of forming an adhesive coating film on the phosphor and the barrier rib; and a step of laying a light detector on the adhesive coating film so that the barrier rib provided on a scintillator panel and a light detection pixel provided on the light detector face each other, and the barrier rib is located between the adjacent light detection pixels, and curing the adhesive coating film to form an adhesive layer.

### [Advantageous Effects of Invention]

According to the present invention, since a barrier rib having a high strength can be formed with high accuracy in a large area, and visible light emitted by a phosphor can be efficiently utilized, it is possible to provide a radiation detection device for realizing formation of large-size and clear images in photographing.

### [Brief Description of Drawings]

Fig. 1 is a sectional view schematically showing the configuration of a radiation detection device including a scintillator panel of the present invention.
Fig. 2 is a perspective view schematically showing the configuration of the scintillator panel of the present invention.

### [Description of Embodiments]

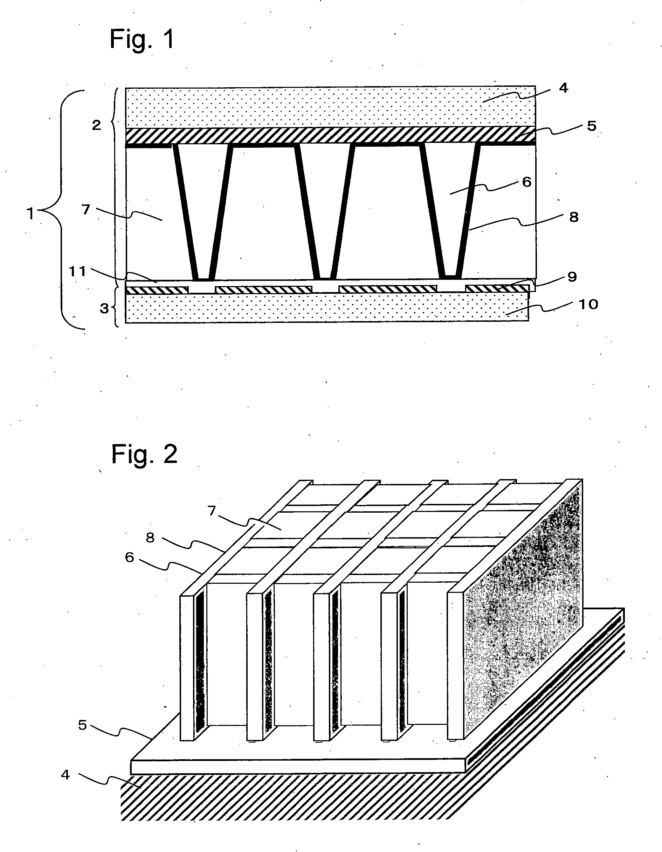

Preferred configurations of a scintillator panel and a radiation detection device using the same of the present invention will be described with reference to Fig. 1 and Fig. 2, but the present invention is not limited thereto.

Fig. 1 is a sectional view schematically showing the configuration of a radiation detection device including a scintillator panel of the present invention. Fig. 2 is a perspective view schematically showing the configuration of the scintillator panel of the present invention. The radiation detection device 1 includes a scintillator panel 2 and a light detector 3. The scintillator panel 2 includes a scintillator layer 7 made of a phosphor, and absorbs energy of an incident radiation such as X-ray to emit electromagnetic wave having a wavelength ranging from 300 to 800 nm, i.e. electromagnetic wave (light) which ranges from ultraviolet light to infrared light with visible light at the center.

The scintillator panel 2 is composed of a sheet-like substrate 4, a grid-like barrier rib 6 formed thereon, and a scintillator layer 7 made of a phosphor filled in a space divided by the barrier rib. A space divided by the grid-like barrier rib 6 is sometimes called a cell. When a radiation is incident from a light detector side 3, it is preferred that a radiation shielding layer 5 is further formed between the substrate 4 and the barrier rib 6. Owing to the radiation shielding layer 5, radiation passed through the scintillator layer 7 is absorbed,' thus enabling shielding of radiation so as not to leak outside the radiation detection device. Further, a reflecting film 8 is preferably formed on the barrier rib 6 and the substrate 4. Owing to the reflecting film 8, light emitted from the phosphor can be reflected without passing through the barrier rib 6 and the substrate 4, and thus light emitted from the scintillator layer 7 can be made to reach a photoelectric conversion pixel 9 formed on a surface of the light detector 3, efficiently.

The light detector can be formed by forming a matrix-like light detection pixel on an insulating substrate such as a glass substrate, a ceramic substrate, or a resin substrate by a photomultiplier tube, a photodiode, a PIN photodiode, or the like, and connecting a switching element composed of a thin film transistor (TFT).

A radiation detection device 1 is formed by laminating a scintillator panel 2 with a light detector 3 so as to face each other. Here, a barrier rib 6 provided on the scintillator panel 2 and a light detection pixel 9 provided on the light detector 3 face each other. In order to enhance sharpness of the radiation detection device, a matrix-like light detection pixel 9 is provided on a part of a surface of the light detector 3, which is not in contact with the barrier rib 6. Here, the phrase "light detection pixel 9 is provided on a part which is not in contact with the barrier rib 6 means that the barrier rib 6 of the scintillator panel 2 is located at a part between adjacent light detection pixels 9, whereby, the light detection pixel 9 and the barrier rib 6 are disposed so as not to be in contact with each other. Each cell of the scintillator panel 2 is divided by a grid-like barrier rib. When the size and pitch of light detection pixels formed in a matrix-like shape are made coincident with the size and pitch of cells of the scintillator panel, each pixel of a photoelectric conversion element is made correspondent with each cell of the scintillator panel. If light emitted in a scintillator layer 7 is scattered by the phosphor, scattered light is reflected by the barrier rib. Therefore, scattered light can be prevented from reaching a neighboring cell. As a result, blurring of images due to light scattering can be reduced, thus enabling high-accuracy photographing.

A scintillator panel 2 and a light detector 3 are laminated with each other by forming an adhesive layer 11 between a barrier rib 6 and a scintillator layer 7 of the scintillator panel 2, and the light detector 3.

The adhesive layer is most preferably formed on the entire surface of the scintillator panel 2. This is because distribution of the intensity of light emitted in the scintillator layer 7 can be more accurately transferred to the light detector 3. Meanwhile, the adhesive layer is not necessarily formed on the entire surface of the scintillator panel 2, and it is also possible to pattern-print the adhesive layer at a specific place of cells, for example, only the scintillator layer 7 or barrier rib 6. In this case, it is preferred to form the adhesive layer in the same shape for each cell since the intensity of light between cells can be more accurately transferred to the light detector.

The adhesive layer 11 preferably has high transparency so as to suppress absorption of emitted light, thus enhancing transmission properties thereof. The method for forming the adhesive layer 11 includes, for example, a method in which a resin for forming the adhesive layer 11 is applied on a barrier rib 6 and a scintillator layer 7 to thereby cause close contact with a light detector 3, and then the resin is cured by means such as heating or irradiation with ultraviolet ray. The adhesive layer 11 enables prevention of positional displacement between the scintillator panel 2 and the light detector 3, which face each other. It is also possible to reduce a variation in height of the barrier rib 6 by the adhesive layer 11. As a result, a distance between the scintillator layer 7 and the light detection pixel 9 becomes constant, thus making it possible to more efficiently guide emitted light to the light detection pixel 9 in a state of less variation between pixels. Thus, the radiation detection device of the present invention can realize clear image quality with high luminous efficiency.

The adhesive layer 11 preferably has a thickness of 5 to 50 µm. The thickness of the adhesive layer of less than 5 µm leads to deterioration of adhesion. Meanwhile, the thickness of the adhesive layer of more than 50 µm leads to absorption of emitted light, and the occurrence of blurring due to light scattering.

The material for forming an adhesive layer 11 having high transparency includes, for example, an optically transparent thermosetting or photocurable resin. Specifically, a resin selected from the group consisting of an acrylic resin, an epoxy resin, a polyester resin, a butyral resin, a polyamide resin, a silicone resin, and ethyl cellulose is preferable. If necessary, these resins can be appropriately blended with additives such as a crosslinking agent, a plasticizer, a tackifier, a filler, or a deterioration preventive agent.

Radiation is preferably incident from a light detector 3 side. When radiation is incident from the light detector 3 side, a scintillator layer 7 in the vicinity of a light detection pixel 9 emits light most intensely, leading to an improvement in light extraction efficiency. Formation of a radiation shielding layer on a surface of a substrate of a scintillator panel 2, and use of a substrate made of a radiation shielding material enable shielding of radiation so as not to leak outside the radiation detection device.

The material of a light detector side substrate 10 is preferably a material having high transmission properties of radiation, and various glasses, polymer materials, metals, and the like can be used. For example, it is possible to use glass sheets made of glasses such as quartz, borosilicate glass, and chemically reinforced glass; ceramic substrates made of ceramics such as sapphire, silicon nitride, and silicon carbide; semiconductor substrates made of semiconductors such as silicon, germanium, gallium arsenide, gallium phosphide, and gallium nitrogen; polymer films (plastic films) such as a cellulose acetate film, a polyester film, a polyethylene terephthalate film, a polyamide film, a polyimide film, a triacetate film, a polycarbonate film, and a carbon fiber reinforced resin sheet; metal sheets such as an aluminum sheet, an iron sheet, and a copper sheet; and metal sheets having a coating layer of a metal oxide, and amorphous carbon substrates. Of these, a plastic film and a glass sheet are preferable in view of flatness and heat resistance. Since weight reduction of the scintillator panel is promoted for pursuing convenience of transportation of the scintillator panel, the glass sheet is preferably a thin glass.

Meanwhile, a substrate made of a material having transmission properties of radiation, which is the same as that of a light detector side substrate 10, may be used as a substrate 4 of a scintillator panel side. However, when radiation is incident from a light detector 3 side, a substrate made of a radiation shielding material, namely, a radiation shielding substrate is preferably used for the purpose of shielding radiation so as not to leak outside a radiation detection device. Examples of the radiation shielding substrate include metal sheets such as an iron sheet and a lead sheet; or glass sheets or films containing heavy metals such as iron, lead, gold, silver, copper, platinum, tungsten, bismuth, tantalum, and molybdenum. When a radiation shielding layer 5 is formed between a substrate 4 and a barrier rib 6, it became less necessary that the substrate 4 is a radiation shielding substrate.

Examples of the material of the radiation shielding layer 5 include materials capable of absorbing radiation, such as glasses or ceramics containing heavy metals such as iron, lead, gold, silver, copper, platinum, tungsten, bismuth, tantalum, and molybdenum.

The radiation shielding layer 5 can be formed, for example, by applying a paste for radiation shielding layer, prepared by dispersing an organic component and an inorganic powder including the above-mentioned materials in a solvent to a substrate, followed by drying to form a coating film, and firing the coating film at a temperature of preferably 500 to 700°C, and more preferably 500 to 650°C.

It is preferred that the radiation shielding layer and the barrier rib are simultaneously fired since the number of steps is reduced: In order to prevent dissolution and peeling from occurring when a paste for barrier rib is applied, it is also preferred to perform thermal curing after forming a coating film using, as an organic component of a paste for radiation shielding layer, a thermosetting organic component containing a polymerizable monomer, a polymerizable oligomer, or a polymerizable polymer, an a thermal polymerization initiator.

A barrier rib is preferably composed of a material containing, as a main component, a low melting point glass containing 2 to 20% by mass of an alkali metal oxide in view of durability, heat resistance, and high-definition processing. The material containing, as a main component, a low melting point glass containing 2 to 20% by mass of an alkali metal oxide has appropriate refractive index and softening temperature, and is suitable for forming a narrow barrier rib with high accuracy in a large area. The low melting point glass refers to a glass having a softening temperature of 700°C or lower. The phrase "containing, as a main component, a low melting point glass containing 2 to 20% by mass of an alkali metal oxide" means that a low melting point glass containing 2 to 20% by mass of an alkali metal oxide accounts for 50 to 100% by mass of a material constituting the barrier rib.

A method for manufacturing a scintillator panel of the present invention preferably includes: a step of forming a photosensitive paste coating film by applying a photosensitive paste containing a low melting point glass and a photosensitive organic component onto a substrate; an exposure step of exposing the obtained photosensitive paste coating film to light; a development step of dissolving and removing a part of the exposed photosensitive paste coating film which is soluble in a developer; a firing step of heating the photosensitive paste coating film pattern after development to a firing temperature of 500 to 700°C to thereby remove the organic component, and soften and sinter the low melting point glass, thus forming a barrier rib; forming a metallic reflecting film on the barrier rib; and a step of filling cells divided by the barrier rib with a phosphor.

In the exposure step, a necessary part of the photosensitive paste coating film is photocured, or an unnecessary part of the photosensitive paste coating film is photodecomposed by exposure to add contrast of dissolution of the photosensitive paste coating film in a developer. In the development step, a part of the exposed photosensitive paste coating film which is soluble in a developer is removed with a developer to obtain a photosensitive paste coating film pattern in which only a necessary part of the coating film remains.

In the firing step, the obtained photosensitive paste coating film pattern is fired at a temperature of 500 to 700°C, preferably 500 to 650°C, whereby the organic component is decomposed and removed, and the low melting point glass is softened and sintered to form a barrier rib containing a low melting point glass: In order to completely remove the organic component, the firing temperature is preferably 500°C or higher. If the firing temperature is higher than 700°C, deformation of the substrate increases when a general glass substrate is used as the substrate, and therefore the firing temperature is preferably 700°C or lower.

The method of the present invention is capable of forming a barrier rib with high accuracy as compared to a method in which a glass paste is printed by laminating by a multi-layer screen printing and then fired.

The photosensitive paste is preferably composed of an organic component having photosensitivity, and an inorganic powder containing a low melting point glass which contains 2 to 20% by mass of an alkali metal oxide. The organic component is required in a given amount so as to form a photosensitive paste coating film pattern before firing. If the amount of the organic component is excessively large, the amount of substances to be removed in the firing step increases, so that the shrinkage rate after firing becomes large, and thus pattern defects are likely to occur in the firing step. Meanwhile, an excessively small amount of the organic component may not be preferable since miscibility and dispersibility of an inorganic powder in the paste deteriorate, so that not only defects are likely to occur during firing, but also coatability of the paste deteriorates due to an increase in viscosity of the paste, and also an adverse influence is exerted on stability of the paste. Therefore, the content of the inorganic powder in the photosensitive paste is preferably 30 to 80% by mass, and more preferably 40 to 70% by mass. The content of the low melting point glass is preferably 50 to 100% by mass based on the total of the inorganic powder. The content of the low melting point glass of less than 50% by mass based on the inorganic powder is not preferable since sintering does not satisfactorily proceed in the firing step, leading to a decrease in strength of the barrier rib thus obtained.

In order to ensure that the organic component is removed almost completely and the barrier rib obtained has a given strength in the firing step, it is preferable to use, as the low melting point glass, a low melting point glass containing a low melting point glass having a softening temperature of 480°C or higher. If the softening temperature is lower than 480°C, the low melting point glass is softened before the organic component is sufficiently removed during firing, thus incorporating the residue of the organic component into the glass. In this case, the organic component may be gradually released later to cause deterioration of product quality. The residue of the organic component incorporated into the glass may cause coloration of the glass. When a low melting point glass powder having a softening temperature of 480°C or higher is used and firing is performed at 500°C or higher, the organic component can be completely removed. As mentioned above, the firing temperature in the firing step is necessarily 500 to 700°C, and preferably 500 to 650°C, and thus the softening temperature of the low melting point glass is preferably 480 to 680°C, and more preferably 480 to 620°C.

The softening temperature is determined by extrapolating a heat absorption completion temperature at an endothermic peak by a tangent method from a DTA curve obtained by measuring a sample using a differential thermal analyzer (DTA, "Differential Type Differential Thermal Balance TG8120" manufactured by Rigaku Corporation). Specifically, an inorganic powder as a measurement sample is measured by elevating the temperature at 20°C/minute from room temperature with an alumina powder as a standard sample using a differential thermal analyzer to obtain a DTA curve. A softening point Ts determined by extrapolating a heat absorption completion temperature at an endothermic peak by a tangent method from the obtained DTA curve is defined as a softening temperature.

In order to obtain a low melting point glass, it is possible to use a metal oxide selected from the group consisting of lead oxide, bismuth oxide, zinc oxide, and alkali metal oxide, which are materials effective for lowering the melting point of glass. Of these, an alkali metal oxide is preferably used to thereby adjust the softening temperature of glass. Generally, the alkali metal refers to lithium, sodium, potassium, rubidium and cesium, while the alkali metal oxide for use in the present invention refers to a metal oxide selected from the group consisting of lithium oxide, sodium oxide, and potassium oxide.

In the present invention, the content X of an alkali metal oxide (M₂O) in the low melting point glass is preferably within a range of 2 to 20% by mass. If the content of the alkali metal oxide is less than 2% by mass, the softening temperature becomes high, thus requiring to perform the firing step at a high temperature. Therefore, when a glass substrate is used as the substrate, the scintillator panel thus obtained is distorted or defects occur in the barrier rib due to deformation of the substrate in the firing step. If the content of the alkali metal oxide is more than 20% by mass, the viscosity of glass decreases too much in the firing step. Therefore, the shape of the barrier rib obtained is likely to be distorted. Further, the porosity of the barrier rib thus obtained becomes excessively small, leading to a decrease in light emission luminance of the scintillator panel thus obtained.

Further, it is preferred to add 3 to 10% by mass of zinc oxide, in addition to the alkali metal oxide, so as to adjust the viscosity of glass at a high temperature. If the content of zinc oxide is less than 3% by mass, the viscosity of glass at a high temperature tends to become high. The content of zinc oxide is more than 10% by mass, the cost of glass tends to increase.

Further, inclusion of silicon oxide, boron oxide, aluminum oxide, or an oxide of an alkali earth metal in the low melting point glass, in addition to the alkali metal oxide and zinc oxide, enables control of stability, crystallinity, transparency, refractive index, or thermal expansion characteristic of the low melting point glass. The composition of the low melting point glass is preferably adjusted within a range of the composition range mentioned below since it is possible to prepare a low melting point glass having a viscosity characteristic suitable for the present invention.

Alkali metal oxide: 2 to 20% by mass
Zinc oxide: 3 to 10% by mass
Silicon oxide: 20 to 40% by mass
Boron oxide: 25 to 40% by mass
Aluminum oxide: 10 to 30% by mass
Alkali earth metal oxide: 5 to 15% by mass

The alkali earth metal refers to one or more metals selected from the group consisting of magnesium, calcium, barium, and strontium.

The particle diameter of inorganic particles containing a low melting point glass can be evaluated using a particle size distribution analyzer ("MT 3300" manufactured by NIKKISO CO., LTD.). As a measurement method, an inorganic powder is charged in a sample chamber filled with water, and subjected to an ultrasonic treatment for 300 seconds, followed by the measurement.

The 50% volume average particle diameter (D50) of the low melting point glass is preferably 1.0 to 4.0 µm. If D50 is less than 1.0 µm, particles strongly agglomerate and it becomes difficult to achieve uniform dispersibility, leading to deterioration of flow stability of a paste. In this case, when a paste is applied, uniformity of thickness of the coating film deteriorates. If D50 is more than 4.0 µm, surface unevenness of a sintered body thus obtained increases, thus causing breakage of a pattern in the subsequent step.

The photosensitive paste may contain, as the filler, a high melting point glass which is not softened even at 700°C, and ceramic particles such as particles of silicon oxide, aluminum oxide, titanium oxide, or zirconium oxide, in addition to the above-mentioned low melting point glasses. The filler, when used together with the low melting point glass, has the effect of controlling the shrinkage rate after firing of a paste composition and retaining the shape of the barrier rib to be formed. However, if the ratio of the filler to the total inorganic powder is more than 50% by mass, sintering of the low melting point glass is hindered to cause a problem such as a reduction in strength of the barrier rib, unfavorably. The filler preferably has an average particle diameter of 0.5 to 4.0 µm for the same reason as that of the low melting point glass.

In the photosensitive paste, the refractive index n1 of the low melting point glass and the refractive index n2 of the organic component preferably satisfy a relation: -0.1 < n1 - n2 < 0.1, more preferably -0.01 ≤ n1 - n2 ≤ 0.01, and more preferably -0.005 ≤ n1 - n2 ≤ 0.005. By satisfying these conditions, light scattering at the interface between the low melting point glass and the photosensitive organic component is suppressed in the exposure step, thus enabling formation of a pattern with high accuracy. Adjustment of the blending ratio of oxides constituting the low melting point glass makes it possible to obtain a low melting point glass having both preferable thermal characteristics and preferable refractive index.

The refractive index of the low melting point glass can be' measured by a Becke line detection method. A refractive index at 25°C and at a wavelength of 436 nm (g-line) was defined as the refractive index of the low melting point glass. The average refractive index of the organic component can be determined by measuring a coating film composed of an organic component by ellipsometry. A refractive index at 25°C and a wavelength of 436 nm (g-line) was defined as the refractive index of the organic component.

When the photosensitive paste contains a photosensitive organic component as an organic component, pattern processing can be performed by the above-mentioned photosensitive paste method. Use of a photosensitive monomer, a photosensitive oligomer, a photosensitive polymer, or a photo-polymerization initiator as the photosensitive organic component enables control of reactivity. Here, the photosensitivity in the photosensitive monomer, the photosensitive oligomer, and the photosensitive polymer means that when the paste is irradiated with active ray, the photosensitive monomer, the photosensitive oligomer, or the photosensitive polymer undergoes a.reaction of photo-crosslinking, photo-polymerization, or the like to change the chemical structure.

The photosensitive monomer is a compound having an active carbon-carbon double bond, and examples thereof include nonfunctional compounds and polyfunctional compounds having a vinyl group, an acryloyl group, a methacryloyl group, or an acrylamide group as a functional group. Particularly, it is preferable that the organic component contains 10 to 80% by mass of a compound selected from the group consisting of polyfunctional acrylate compounds and polyfunctional methacrylate compounds from the viewpoint of increasing the crosslinking density during curing by a photoreaction to improve pattern formability. Since various compounds have been developed as the polyfunctional acrylate compounds and polyfunctional methacrylate compounds, it is possible to appropriately select from among those compounds, taking reactivity, refractive index, and the like into consideration.

It is possible to preferably use, as the photosensitive oligomer or the photosensitive polymer, an oligomer or polymer having an active carbon-carbon unsaturated double bond. The photosensitive oligomer or the photosensitive polymer is obtained, for example, by copolymerizing a carboxyl group-containing monomer such as acrylic acid, methacrylic acid, itaconic acid, crotonic acid, maleic acid, fumaric acid, vinylacetic acid, or an acid anhydride thereof, with a monomer such as a methacrylic acid ester, an acrylic acid ester, styrene, acrylonitrile, vinyl acetate, or 2-hydroxyacrylate. It is possible to use, as a method for introducing an active carbon-carbon unsaturated double bond into an oligomer or a polymer, a method in which an ethylenically unsaturated compound having a glycidyl group or an isocyanate group, acrylic acid chloride, methacrylic acid chloride, or acryl chloride, or a carboxylic acid such as maleic acid is reacted with a mercapto group, an amino group, a hydroxyl group, or a carboxyl group in an oligomer or a polymer, or the like.

It is possible to obtain a photosensitive paste, which is less likely to cause pattern defects in the firing step, by using, as the photosensitive monomer or the photosensitive oligomer, a monomer or oligomer having a urethane bond. In the present invention, rapid shrinkage is less likely to occur in the process of proceeding of sintering of a glass in the later stage of the firing step by using a low melting point glass as the glass. This enables suppression of breakage of the barrier rib in the firing step. In addition, when a compound having a urethane structure is used for the organic component, stress relaxation occurs in the process of decomposition and distillation of the organic component in the early stage of the firing step, thus enabling suppression of breakage of the barrier rib within a wide temperature range.

The photo-polymerization initiator is a compound which generates radicals when irradiated with active ray. Specific examples thereof include benzophenone, methyl o-benzoylbenzoate, 4,4-bis(dimethylamino)benzophenone, 4,4-bis(diethylamino)benzophenone, 4,4-dichlorobenzophenone, 4-benzoyl-4-methyl diphenyl ketone, dibenzyl ketone, fluorenone, 2,2-dimethoxy-2-phenylacetophenone, 2-hydroxy-2-methylpropiophenone, thioxanthone, 2-methylthioxanthone, 2-chlorothioxanthone, 2-isopropylthioxanthone, diethylthioxanthone, benzyl, benzyl methoxyethyl acetal, benzoin, benzoin methyl ether, benzoin butyl ether, anthraquinone, 2-t-butylanthraquinone, anthrone, benzanthrone, diberizosuberone, methylene anthrone, 4-azidobenzalacetophenone, 2,6-bis(p-azidobenzylidene)cyclohexanone, 2,6-bis(p-azidobenzylidene)-4-methylcyclohexanone, 1-phenyl-1,2-butadione-2-(O-methoxycarbonyl)oxime, 1-phenyl-1,2-propanedione-2-(O-ethoxycarbonyl)oxime, 1,3-diphenylpropanetrione-2-(O-ethoxycarbonyl)oxime, 1-phenyl-3-ethoxypropanetrione-2-(O-benzoyl)oxime, Michler ketone, 2-methyl-1-[4-(methylthio)phenyl]-2-morphorino-1-propanone, 2-benzyl-2-dimethylamino-1-(4-morpholinophenyl)butanone-1, naphthalenesulfonyl chloride, quinolinesulfonyl chloride, N-phenylthioacridone, benzothiazole disulfide, triphenylphosphine, benzoin peroxide, eosine, and combinations of a photo-reductive pigment such as methylene blue and reducing agents such as ascorbic acid and triethanolamine. Two or more of these compounds may be used in combination.

The photosensitive paste may contain, as a binder, a copolymer having a carboxyl group. The copolymer having a carboxyl group is obtained, for example, by selecting a carboxyl group-containing monomer such as acrylic acid, methacrylic acid, itaconic acid, crotonic acid, maleic acid, fumaric acid, vinylacetic acid, or an acid anhydride thereof, and the other monomer such as a methacrylic acid ester, an acrylic acid ester, styrene, acrylonitrile, vinyl acetate, or 2-hydroxy acrylate, and copolymerizing the monomer using an initiator such as azobisisobutyronitrile. A copolymer having an acrylic acid ester or a methacrylic acid ester and acrylic acid or methacrylic acid as copolymerization components is preferably used as the copolymer having a carboxyl group because of low thermal decomposition temperature during firing.

The photosensitive paste becomes a paste having excellent solubility in an aqueous alkali solution when containing a copolymer having a carboxyl group. The acid value of the copolymer having a carboxyl group is preferably 50 to 150 mg KOH/g. When the acid value is 150 mg KOH/g or less, the allowable range of development can be widened. When the acid value is 50 mg KOH/g or more, solubility of the unexposed area in a developer does not decrease. Therefore, there is no need to increase the concentration of the developer and peeling of the exposed area is prevented, thus making it possible to obtain a high-definition pattern can be obtained. Further, it is also preferable that the copolymer having a carboxyl group has an ethylenically unsaturated group on a side chain. Examples of the ethylenically unsaturated group include an acrylic group, a methacrylic group, a vinyl group, an allyl group, and the like.

The photosensitive paste is prepared by optionally adding an organic solvent and a binder to a low melting point glass and a photosensitive organic component containing a photosensitive monomer, a photosensitive oligomer, a photosensitive polymer, or a photo-polymerization initiator, and compounding various components so as to achieve a predetermined composition, and uniformly mixing and dispersing the mixture using a three-roll roller or a kneader.

The viscosity of the photosensitive paste can be appropriately adjusted by the addition ratio of an inorganic powder, a thickener, an organic solvent, a polymerization inhibitor, a plasticizer, and a precipitation preventive agent, and is preferably within a range of 2 to 200 Pa·s. For example, when the photosensitive paste is applied to the substrate by a spin coating method, the viscosity is preferably 2 to 5 Pa·s. When the photosensitive paste is applied to the substrate by a screen printing method to achieve a film thickness of 10 to 20 µm in a single application, the viscosity is preferably 50 to 200 Pa·s. When a blade coater method or a die coater method, the viscosity is preferably 10 to 50 Pa·s.

A barrier rib can be formed by applying the thus prepared photosensitive paste onto a substrate, and forming a desired pattern using a photolithography method, followed by firing. An example of manufacturing a barrier rib by the photolithography method using the above-mentioned photosensitive paste will be described below, but the present invention is not limited thereto.

The photosensitive paste is applied onto the whole or part of a surface of a substrate to form a photosensitive paste coating film. It is possible to use as a coating method, a screen printing method, or a method using a bar coater, a roll coater, a die coater, or a blade coater. The coating thickness can be adjusted by selecting the number of applications, mesh of the screen, and a viscosity of the paste.

Subsequently, an exposure step is performed. An exposure method is commonly a method in which exposure is performed through a photomask as in usual photolithography. In this case, a photosensitive paste coating film is exposed through a photomask having a predetermined opening corresponding to the objective pattern of a barrier rib. Alternatively, a method of directly drawing by laser light without using a photomask may be used. It is possible to use, as an exposure device, a proximity exposure machine, or the like. When exposure of a large area is performed, a large area can be exposed using an exposure machine having a small exposure area by performing exposure while transferring after applying the photosensitive paste onto the substrate. Examples of the active ray for use in exposure include near infrared ray, visible ray, and ultraviolet ray. Of these, ultraviolet ray is most preferable. It is possible to use, as a light source thereof, for example, a low-pressure mercury lamp, a high-pressure mercury lamp, an ultra-high pressure mercury lamp, a halogen lamp, or a germicidal lamp, and an ultra-high pressure mercury lamp is preferable. Exposure conditions vary depending on the thickness of the photosensitive paste coating film, and is usually performed for 0.01 to 30 minutes using an ultra-high pressure mercury lamp with a power of 1 to 100 mW/cm².

After exposure, development is performed by making use of a difference in solubility in a developer between the exposed area and the unexposed area of the photosensitive paste coating film to obtain a desired grid-like photosensitive paste coating film pattern. Development is performed using a dipping method, a spray method, or a brush method. It is possible to use a solvent into which an organic component in a paste is soluble, for the developer. Preferably, the developer contains water as a main component. When a compound having an acidic group such as a carboxyl group exists in the paste, development can be performed with an aqueous alkali solution. It is possible to use, as the aqueous alkali solution, an aqueous inorganic alkali solution such as that of sodium hydroxide, sodium carbonate or calcium hydroxide can be used, but use of an aqueous organic alkali solution is more preferable because an alkali component is easily removed during firing. Examples of the organic alkali include tetramethylammonium hydroxide, trimethylbenzylammonium hydroxide, monoethanolamine, diethanolamine, and the like. The concentration of the aqueous alkali solution is preferably 0.05 to 5% by mass, and more preferably 0.1 to 1% by mass. If the alkali concentration is excessively low, a soluble part may not be removed, and if the alkali concentration is excessively high, a pattern part may be peeled and a non-soluble part may be corroded. The development temperature during development is preferably 20 to 50°C in view of process control.

Next, a firing step is performed in a firing furnace. The atmosphere and temperature for the firing step vary depending on types of the photosensitive paste and the substrate, but firing is performed in air or in an atmosphere of nitrogen, hydrogen, or the like. It is possible to use, as the firing furnace, a batch-type firing furnace or a belt-type continuous firing furnace. Preferably, firing is performed by normally retaining at a temperature of 500 to 700°C for 10 to 60 minutes. The firing temperature is more preferably 500 to 650°C. By the step mentioned above, the organic component is removed from the grid-like photosensitive paste coating film pattern, and the low melting point glass contained in the coating film pattern is softened and sintered to obtain a barrier rib member in which a grid-like barrier rib substantially composed of an inorganic substance is formed onto a substrate.

For preventing leakage of light from the barrier rib, a reflecting film is preferably formed on a surface of the barrier rib and a substrate surface which is not provided with the barrier rib. The material of the reflecting film is not particularly limited, but it is preferred to use a material through which radiation transmits, and reflects visible light that is electromagnetic wave of 300 to 800 nm emitted by the phosphor. Of these, metal such as silver, gold, aluminum, nickel, or titanium, or metal oxide such as TiO₂, ZrO₂, Al₂O₃, or ZnO, which is less likely to deteriorate, is preferable. In the present invention, the surface of the barrier rib refers to a surface of the barrier rib except for a surface where the barrier rib and the substrate are not in contact with each other, namely, the top of the barrier rib and the side of the barrier rib.

Formation of the reflecting film after formation of the barrier rib is preferable since reflecting films having the same material can be simultaneously formed on the surface of the barrier rib and the substrate surface which is not provided with the barrier rib. As a result, reflecting films having similar reflectivities can be formed on the side surface of the barrier rib and the substrate surface, so that visible light emitted by the phosphor can be uniformly guided to the sensor side more efficiently. It is preferable that a reflecting film is not formed on the substrate surface before formation of the barrier rib. In other words, it is preferable that a reflecting film is not formed on the surface where the barrier rib and the substrate are in contact with each other. This is because in the step of exposing the barrier rib, exposure light is scattered by the reflecting film, thus failing to form a high-definition pattern cannot be formed.

The method for forming a reflecting film is not particularly limited, and various film formation methods such as a vacuum film formation method, a paste coating method, and a spraying method using a spray can be used. Of these, a vacuum film formation method is preferable since a uniform reflecting film can be formed at comparatively low temperature. Examples of the vacuum film formation method include vacuum deposition, sputtering, ion plating, CVD, and laser ablation, and sputtering is more preferable since a uniform film can be formed on the side surface of the barrier rib. If a temperature higher than the firing temperature of the barrier rib is applied during formation of the reflecting film, the barrier rib is deformed, and therefore the temperature during formation of the reflecting film is preferably lower than the temperature during formation of the barrier rib.

In order to prevent an improvement in reflectance of light and leakage of light from the barrier rib, a light shielding film is preferably formed between the barrier rib and the reflecting film. The material of the light shielding film is not particularly limited, and a metal film of chromium, nichrome, tantalum, or the like, a resin containing a black pigment such as carbon, or the like can be used. The method for forming a light shielding film is not particularly limited, and a method including applying a pasty material, or various kinds of vacuum film formation methods can be used.

The height L1 of the barrier rib is preferably 100 to 3,000 µm, and more preferably 160 to 500 µm. If L1 is more than 3,000 µm, processability in the case of forming the barrier rib deteriorates. Meanwhile, if L1 is less than 100 µm, the amount of fillable phosphor decreases, leading to a decrease in light emission luminance of the scintillator panel thus obtained.

The distance L2 of the adjacent barrier rib is preferably 30 to 1,000 µm. If L2 is less than 30 µm, processability in the case of forming the barrier rib deteriorates. If L2 is too large, accuracy of images of the scintillator panel thus obtained deteriorates. The height L1 of the barrier rib is preferably larger than the distance L2 of the barrier rib. This is because an increase in height of the barrier rib leads to an increase in amount of the phosphor to be filled, thus improving light emission luminance.

Regarding the barrier rib width, the width (bottom width) L3 at the interface where the barrier rib and the substrate are in contact with each other is preferably larger than the width L4 of the top (light detector side) of the barrier rib. It is possible to improve reflection efficiency and extraction efficiency of emitted light of the scintillator layer by taking a pseudo-trapezoidal structure in which the barrier rib width of the light detector side is small. When radiation is incident from the light detector side, utilization efficiency of radiation can be enhanced by increasing the filling amount of the phosphor in the vicinity of the light detector side. Further, when the reflecting film is formed on the barrier rib surface after forming the barrier rib, if L4 is larger than L3, the barrier rib side in the vicinity of the top of the barrier rib is shielded by the top of the barrier rib, thus failing to form a reflecting film.

The bottom width L3 is preferably 10 to 150 µm, and the top width L4 is preferably 5 to 80 µm. If L3 is less than 10 µm, defects of the barrier rib are likely to occur during firing. Meanwhile, if L3 is more than 150 µm, the amount of the phosphor capable of being filed in the space divided by the barrier rib decreases. If L4 is less than 5 µm, the strength of the barrier rib decreases. Meanwhile, if L4 is more than 80 µm, the range capable of extracting emitted light of the scintillator layer is narrowed. L4 is more preferably made shorter than the distance between adjacent light detection pixels.

An aspect ratio of L1 to L3 (L1/L3) is 1.0 to 25.0. A barrier rib having a larger aspect ratio (L1/L3) can be filled with a larger amount of the phosphor because of its wide space per pixel divided by the barrier rib.

An aspect ratio of L1 to L2 (L1/L2) is 1.0 to 3.5. A barrier rib having a larger aspect ratio (L1/L2) becomes one pixel divided with high definition, and also the space per pixel can be filled with a larger amount of the phosphor.

The height L1 of the barrier rib and the distance L2 of the barrier rib can be measured by exposing a barrier rib cross-section perpendicular to the substrate, and observing the cross-section by a scanning electron microscope ("S4600", manufactured by Hitachi, Ltd.). The width of the barrier rib at a contact part between the barrier rib and the substrate is defined as L3. When a radiation shielding layer exists between the barrier rib and the substrate, the width of the barrier rib at a contact part between the barrier rib and the shielding layer is defined as L3. The width of the topmost of the barrier rib is defined as L4. When it is difficult to accurately grasp the top of the barrier rib or the bottom of the barrier rib since the top of the barrier rib is rounded or the topmost of the barrier rib undergoes hemming, 90% height width (L90) may be measured in place of L4 and 10% height width (L10) may be measured in place of L3. L90 refers to a line width of the part of the height of 90 from the bottom surface of the barrier rib when L1 is 100. Similarly, L10 refers to a line width of the part of the height of 10 from the bottom surface of the barrier rib when L1 is 100.

A scintillator panel can be completed by filling cells divided by the barrier rib with a phosphor. Here, the cell refers to a space divided by a grid-like barrier rib. The phosphor filled in the cell is referred to as a scintillator layer.

It is possible to use, as the phosphor, various known phosphor materials. Particularly, a material having a high conversion rate of radiation to visible light, such as CsI, Gd₂O₂S, Lu₂O₂S, Y₂O₂S, LaCl₃, LaBr₃, LaI₃, CeBr₃, CeI₃, LuSiO₅, or Ba (Br, F, Zn), but the phosphor is not limited thereto. In order to enhance luminous efficiency, various activators may be added. For example, in the case of CsI, a mixture of CsI and sodium iodide (NaI) in an arbitrary molar ratio, or CsI containing activation substances such as indium (In), thallium (Tl), lithium (Li), potassium (K), rubidium (Rb) or sodium (Na) is preferable. Further, a thallium compound such as thallium bromide (TlBr), thallium chloride (TlCl), or thallium fluoride (TlF, TlF₃) can also be used as an activator:

In order to form a scintillator layer, it is possile to use a method in which crystalline CsI is deposited by vacuum deposition (in this case, it is also possible to co-deposit a thallium compound such as thallium bromide) and a method in which a slurry of a phosphor dispersed in water is applied to a substrate. However, it is preferred to use a method in which a phosphor paste prepared by mixing a phosphor powder, an organic binder such as ethyl cellulose or an acrylic resin, and an organic solvent such as terpineol or γ-butyrolactone is applied using screen printing or a dispenser.

The amount of the phosphor filled in cells divided by the barrier rib is preferably 50% to 100% in terms of a volume fraction of the phosphor. If the phosphor filling ratio is less than 50%, efficiency of converting incident X-ray into visible light decreases. In order to enhance conversion efficiency of incident X-ray, it is also possible to enhance efficiency of conversion into visible light by increasing the aspect ratio (L1/L2) of the barrier rib height to the barrier rib pitch. However, it is preferred to further enhance conversion efficiency by filling the space of the cell with a phosphor with high density.

A radiation detection device is produced by laminating the scintillator panel thus produced and a light detector with each other. The method for manufacturing a radiation detection device preferably includes a step of forming an adhesive coating film on the phosphor and the barrier rib of the scintillator pane; and a step of laying a light detector on the adhesive coating film so that the barrier rib provided on a scintillator panel and a light detection pixel provided on the light detector face each other, and the barrier rib is located between the adjacent light detection pixels, and curing the adhesive coating film to form an adhesive layer.

In the step of forming an adhesive coating film, an adhesive is applied onto a barrier rib and a scintillator layer. It is possible to use, as the coating method, methods such as a screen printing method, and a method using a bar coater, a roll coater, a die coater, blade coater, or the like The thickness of the adhesive coating film can be adjusted by selecting number of coating, mesh of screen, and viscosity of paste. These methods are suited for applying an adhesive on the whole surface of the entire surface of the barrier rib and the scintillator layer. It is also possible to use a transfer method in which an adhesive coating film is once formed on a separately prepared base material and then transferred onto a scintillator, an ink-jet method, a nozzle coating method, and the like. These methods are suited for applying an adhesive only onto a specific place such as a barrier rib or a scintillator layer with an arbitrary pattern.

In the step of laying a light detector on a scintillator panel, a barrier rib provided on a scintillator panel and a light detection pixel provided on a light detector are laid one upon another on the adhesive coating film so as to face with each other, and then the both are closely adhered to each other so that the barrier rib is located between adjacent light detection pixels by making alignment. Whereby, each pixel of a photoelectric conversion element can be made correspondent with each cell of the scintillator panel. In this case, an attention is paid to prevent the scintillator panel from bending.

In this way, it is preferred to remove air bubbles in the adhesive coating film in a state where the scintillator panel and the light detector are laid one upon another through the adhesive coating film. Air bubbles can be removed, for example, by evacuation with heating in a vacuum press.

Thereafter, the adhesive coating film is cured to form an adhesive layer, thus making it possible to obtain a radiation detection device. The adhesive coating film is cured by a method of heating or irradiating with ultraviolet ray according to types of the adhesive.

Since emitted light of the phosphor can be efficiently guided to a light detection pixel, it is preferred to satisfy a relation: λ2 ≥ λ1 ≥ λ3, where λ1, λ2, and λ3 respectively denote an average refractive index of the phosphor, an average refractive index of the light detection pixel, and an average refractive index of the adhesive layer. In order to minimally suppress light scattering at an interface and to efficiently guide emitted light of the phosphor to the light detection pixel, thus improving luminance, a difference in average refractive index between the phosphor and the adhesive layer is preferably less than 0.8. Here, an average refractive index refers to a refractive index of a material when the phosphor or adhesive layer is made of a single material. When the phosphor or adhesive layer is made of plural types of materials, the average refractive index refers to a weighted average of each refractive index.

### [Examples]

The present invention will be described in detail below by way of Examples. However, the present invention is not limited thereto.

### (Raw Materials of Photosensitive Paste for Barrier Rib)

Raw materials used for the photosensitive paste of Examples are as follows. Photosensitive monomer M-1: trimethylolpropane triacrylate Photosensitive monomer M-2: tetrapropylene glycol dimethacrylate Photosensitive polymer: product of addition reaction of 0.4 equivalent of glycidyl methacrylate with carboxyl groups of a copolymer of methacrylic acid/methyl methacrylate/styrene in a mass ratio of 40/40/30 (weight average molecular weight: 43,000, acid value: 100)
Photo-polymerization initiator:
   2-benzyl-2-dimethylamino-1-(4-morpholinophenyl)butanone-1 ("IC369", manufactured by BASF Corporation)
Polymerization inhibitor:
   1,6-hexanediol-bis[(3,5-di-t-butyl-4-hydroxyphenyl)propionate ])
Ultraviolet ray absorber solution: 0.3 mass% γ-butyrolactone solution of Sudan IV (manufactured by TOKYO OHKA KOGYO Co. , Ltd.) Organic resin binder: ethyl cellulose (manufactured by Hercules Inc.)
Viscosity modifier: Flownon EC121 (manufactured by KYOEISHA CHEMICAL CO., LTD.)
Solvent: γ-butyrolactone
Low melting point glass powder:
   27% by mass of SiO₂, 31% by mass of B₂O₃, 6% by mass of ZnO, 7% by mass of Li₂O, 2% by mass of MgO, 2% by mass of CaO, 2% by mass of BaO, and 23% by mass of Al₂O₃, refractive index (ng) : 1.56, glass softening temperature: 588°C, thermal expansion coefficient: 70 × 10⁻⁷, average particle diameter: 2.3 µm

### (Preparation of Paste for Barrier Rib)

Photosensitive Paste A for Barrier Rib: Four (4) parts by mass of a photosensitive monomer M-1, 6 parts by mass of a photosensitive monomer M-2, 24 parts by mass of a photosensitive polymer, 6 parts by mass of a photo-polymerization initiator, 0.2 part by mass of a polymerization inhibitor, and 12.8 parts by mass of an ultraviolet ray absorber solution were dissolved in 38 parts by mass of a solvent under heating at a temperature of 80 °C. After cooling the obtained solution, 9 parts by mass of a viscosity modifier was added to prepare an organic solution. The refractive index (ng) of an organic coating film obtained by applying the organic solution to a glass substrate and drying the applied solution was 1.555.

Next, 30 parts by mass of a low melting point glass powder and 10 parts by mass of a high melting point glass powder were added to 60 parts by mass of an organic solution 1, and then the mixture was kneaded by a three-roll kneader to prepare a photosensitive paste for barrier rib.

Screen Printing Paste for Barrier Rib: Fifty (50) parts by mass of a terpineol solution containing 10% by mass of ethyl cellulose and 50 parts by mass of a low melting point glass powder were mixed to prepare a screen printing paste for barrier rib. The refractive index (ng) of an organic coating film obtained by applying a terpineol solution containing 10% by mass of ethyl cellulose to a glass substrate and drying the applied solution was 1.49.

### (Light Detector)

On a surface of a glass substrate having a size measuring 500 mm × 500 mm × 0.5 mm in thickness ("OA-10", manufactured by Nippon Electric Glass Co., Ltd.), a PIN type photodiode made of amorphous silicon having a refractive index of 3. 5 and a plurality of light detection pixels made of TFT having a pixel size of 125 µm × 125 µm were formed in a matrix form. Next, a wiring part including a bias wiring for applying a bias to the PIN type photodiode, a driving wiring for applying a driving signal to TFT, a signal wiring for outputting a signal charge transferred by TFT, and the like was formed of aluminum to produce a light detector.

### (Example 1)

On a glass substrate having a size measuring 500 mm × 500 mm ("OA-10", manufactured by Nippon Electric Glass Co., Ltd.), a photosensitive paste for barrier rib was applied by a die coater so as to obtain a dry thickness of 500 µm, followed by drying to form a photosensitive paste for barrier rib coating film. Next, the photosensitive paste coating film for barrier rib was exposed at an exposure dose of 700 mJ/cm² by an ultra-high pressure mercury lamp through a photomask having an opening corresponding to a desired barrier rib pattern (chrome mask having a grid-like opening having a pitch of 125 µm and a line width of 10 µm). The exposed photosensitive paste coating film for barrier rib was developed in an aqueous 0.5 mass% ethanolamine solution to remove the unexposed area, thus forming a grid-like photosensitive paste coating film pattern. Further, the photosensitive paste coating film pattern was fired in air at 585°C for 15 minutes to produce a substrate with a grid-like barrier rib having a barrier rib distance L2 of 125 µm, a top width L4 of 10 µm, a bottom width L3 of 20 µm, a barrier rib height L1 of 340 µm, and a size measuring 480 mm × 480 mm formed on a surface thereof.

Next, a gadolinium oxysulfide powder Gd₂O₂S (Gd₂O₂S:Tb) having a particle diameter of 5 µm and a refractive index of 2.2, as a phosphor, was mixed with ethyl cellulose, and then a space divided by the barrier rib was filled with the mixture to produce a scintillator panel in which a volume fraction of a phosphor in the cell is 90%.

Next, on the scintillator pane, a 20 µm thick adhesive coating film made of an acrylic UV-curable adhesive ("WORLD ROCK HRJ", manufactured by Kyoritsu Chemical & Co., Ltd.) was formed, by a die coater, and then the light detector was laid on the adhesive coating film while paying attention to prevent the scintillator panel from bending. In that case, the barrier rib provided on the scintillator panel and the light detection pixel provided on the light detector were allowed to face each other, and the barrier rib was allowed to be located between adjacent light detection pixels. In this way, in a state where the scintillator panel and the light detector are laid one upon another via the adhesive coating film, air bubbles in the adhesive coating film were removed by evacuation with heating at 120 °C in a vacuum press, followed by cooling to room temperature. Thereafter, the adhesive coating film was cured by UV irradiation to form an adhesive layer, thus producing a radiation detection device. The adhesive layer thus formed had an average refractive index of 1.6.

The scintillator panel and the light detector are closely adhered to each other by the thus formed adhesive layer, and defects such as positional displacement and substrate cracks did not occur in the subsequent handling.

Next, X-ray at a voltage of 80 kVp was applied from the light detector side of the radiation detection device, and then the amount of light emitted from the scintillator layer was detected and measured by a light detection pixel and the measured value was regarded as luminance. At this time, a 20 mm thick aluminum filter for removal of soft X-ray was disposed between an X-ray source and a radiation detection device. A rectangular modulation transfer function (MTF) chart made of lead was disposed on the back side (face where no light detection pixel is formed) of the light detector. In the same manner, X-ray at a voltage of 80 kVp was applied through an aluminum filter, and then sharpness was calculated by analyzing X-ray image data obtained by detecting with the light detection pixel using a computer. These values were expressed by a relative value on the assumption that the value of a phosphor solid film including no barrier rib (corresponding to the scintillator panel produced in Comparative Example 3) is regarded as 100. As a result, luminance was 102 and sharpness was 158, and the both exhibited satisfactory value.

### (Example 2)

In the same manner as in Example 1, a substrate, on which a grid-like barrier rib is provided, was produced. Thereafter, an aluminum film, namely, a reflecting film was formed on a barrier rib surface and a substrate surface of the place where no barrier rib is formed by a batch type sputtering system ("SV-9045", manufactured by ULVAC, Inc.). The thickness of the thus formed aluminum film at the barrier rib top was 300 nm, the thickness of the aluminum film of the barrier rib side was 100 nm, and the thickness of the aluminum film on the substrate was 100 nm.

Next, a gadolinium oxysulfide powder having a particle diameter of 5 µm and a refractive index of 2.2, as a phosphor, was mixed with ethyl cellulose having a refractive index of 1.5, and then a space divided by the barrier rib was filled with the mixture to produce a scintillator panel in which a volume fraction of a phosphor in the cell is 90%. Using the thus obtained scintillator panel, a radiation detection device was produced and evaluated in the same manner as in Example 1. As a result, luminance was 120 and sharpness was 210, and the both exhibited satisfactory value.

### (Example 3)

In the same manner as in Example 1, except that the glass substrate of Example 1 was replaced by a tungsten substrate having a size measuring 300 × 300 mm (manufactured by Applied Materials, Inc.), a radiation detection device was produced and evaluated. As a result, noise decreased since X-ray transmitted through the radiation detection device was absorbed to the tungsten substrate, and thus luminance was 110 and sharpness was 165, and the both exhibited satisfactory value.

### (Comparative Example 1)

In the same manner as in Example 1, a scintillator panel filled with a phosphor was produced. Thereafter, in the same manner as in Example 1, except that a predetermined amount of a photocurable sealing resin composed mainly of an acrylic resin was applied on an outer periphery by a dispenser in place of forming an adhesive layer, a radiation detection device was laid and the resin was cured to produce a radiation detection device. At this time, a gap was partially generated between a scintillator panel and a light detector at the center part due to deflection of the substrate. This radiation detection device was evaluated in the same manner as in Example 1. As a result, luminance was 30 and sharpness was 129, and luminance greatly decreased.

### (Comparative Example 2)

On a glass substrate having a size measuring 500 mm × 500 mm ("OA-10", manufactured by Nippon Electric Glass Co., Ltd.), an operation of application of the screen printing paste for barrier rib in a film thickness of 40 µm and drying was repeated to form 12 layers by screen printing at a pitch of 125 µm and a wall width of 35 µm in a longitudinal direction and a transverse direction, using a pattern corresponding to predetermined number of pixels. Thereafter, firing was performed in air at 550 °C to produce a substrate, on which a grid-like barrier rib is provided, in which a distance L2 of the barrier rib is 125 µm, a top width L4 is 52 µm, a bottom width L3 is 45 µm, a height L1 of the barrier rib is 350 µm, and a size corresponding to predetermined number of pixels is a size measuring 480 mm × 480 mm. The thus formed barrier rib was observed. As a result, partial breakage was generated at several places in the face. Thereafter, in the same manner as in Example 1, except that no adhesive layer is formed, a light detector was laid and a substrate peripheral part was interposed by a clip, and then the substrate and the light detector were fixed. In the same manner as in Example 1, a radiation detection device was produced and evaluated. As a result, luminance was 65 and sharpness was 98, and luminance greatly decreased.

### (Comparative Example 3)

In the same manner as in Example 1, except that no barrier rib was formed on the scintillator panel and a phosphor solid film was formed, a radiation detection device was produced. In the same manner as in Example 1, luminance and sharpness were measured.

The above evaluation results reveal that the radiation detection device of the present invention exhibits high light emission luminance, thus enabling realization of high-sharpness images.

### [Reference Signs List]

- 1: Radiation detection device
- 2: Scintillator panel
- 3: Light detector
- 4: Substrate
- 5: Radiation shielding layer
- 6: Barrier rib
- 7: Phosphor (scintillator layer)
- 8: Reflecting film, light shielding film
- 9: Light detection pixel
- 10: Light detector side substrate
- 11: Adhesive layer

### [Industrial Applicability]

The present invention can be usefully used as a radiation detection device which is used in a medical diagnostic apparatus, a nondestructive inspection instrument, and the like.

## Claims

1. A radiation detection device, comprising a substrate, on which a barrier rib is provided, and a light detector, which face each other, wherein
cells divided by the barrier rib are formed in a space between the substrate and the light detector,
the cells are filled with a phosphor,
a light detection pixel is provided on a surface of the light detector, in the place that is not in contact with the barrier rib, and
an adhesive layer is formed between the barrier rib and the phosphor, and the light detector.

2. The radiation detection device according to claim 1, wherein the adhesive layer is formed of a resin selected from the group consisting of an acrylic resin, an epoxy resin, a polyester resin, a butyral resin, a polyamide resin, a silicone resin, and an ethyl cellulose resin.

3. The radiation detection device according to claim 1 or 2, wherein a height L1 of the barrier rib is larger than a distance
L2 of an adjacent barrier rib, and also a width L3 at the interface where the barrier rib and the substrate are in contact with each other is larger than a width L4 of the top of the barrier rib.

4. The radiation detection device according to any one of claims 1 to 3, which satisfies a relation: λ2 ≥ λ1 ≥ λ3, where λ1, λ2, and λ3 respectively denote an average refractive index of the phosphor, an average refractive index of the light detection pixel, and an average refractive index of the adhesive layer.

5. The radiation detection device according to any one of claims 1 to 4, wherein radiation is incident from the light detector side.

6. The radiation detection device according to claim 5, wherein the substrate includes a radiation shielding layer on a surface.

7. The radiation detection device according to claim 5 or 6, wherein the substrate is made of a radiation shielding material.

8. The radiation detection device according to any one of claims 1 to 7, wherein the barrier rib is made of a material containing, as a main component, a low melting point glass containing 2 to 20% by mass of an alkali metal oxide.

9. The radiation detection device according to any one of claims 1 to 8, wherein a reflecting film is formed on a surface of the barrier rib, and a face on the substrate on which the barrier rib is not formed.

10. A method for manufacturing the radiation detection device according to any one of claims 1 to 9, the method comprising:
a step of forming a photosensitive paste coating film by applying a photosensitive paste containing a low melting point glass and a photosensitive organic component onto a substrate;
an exposure step of exposing the obtained photosensitive paste coating film to light;
a development step of dissolving and removing a part of the exposed photosensitive paste coating film which is soluble in a developer;
a firing step of heating the photosensitive paste coating film pattern after development to a firing temperature of 500°C to 700°C to thereby remove the organic component, and soften and sinter the low melting point glass, thus forming a barrier rib;
a step of filling cells divided by the barrier rib with a phosphor;
a step of forming an adhesive coating film on the phosphor and the barrier rib; and
a step of laying a light detector on the adhesive coating film so that the barrier rib provided on a scintillator panel and a light detection pixel provided on the light detector face each other, and the barrier rib is located between the adjacent light detection pixels, and curing the adhesive coating film to form an adhesive layer.
